# EUROPÄISCHE PATENTSCHRIFT

(11) **EP 2 534 697 B1**
(45) Veröffentlichungstag und Bekanntmachung des Hinweises auf die Patenterteilung: **13.01.2016**
(21) Anmeldenummer: 11711746.5
(22) Anmeldetag: 05.02.2011
(51) Int. Cl.: H01L 31/068, H01L 31/0747, H01L 31/0224

(54) **RÜCKSEITENKONTAKTIERTE SOLARZELLE MIT UNSTRUKTURIERTER ABSORBERSCHICHT**
BACK CONTACT SOLAR CELL HAVING AN UNSTRUCTURED ABSORBER LAYER
CELLULE SOLAIRE À CONTACT ARRIÈRE COMPORTANT UNE COUCHE ABSORBANTE NON STRUCTURÉE

(30) Priorität: 09.02.2010 DE 102010007695
(43) Veröffentlichungstag der Anmeldung: 19.12.2012
(73) Patentinhaber: Helmholtz-Zentrum Berlin für Materialien und Energie GmbH, 14109 Berlin (DE)
(72) Erfinder: STANGL, Rolf, 12435 Berlin (DE); KORTE, Lars, 10245 Berlin (DE)
(86) Internationale Anmeldenummer: PCT/DE2011/000113
(87) Internationale Veröffentlichungsnummer: WO 2011/098069

(56) Entgegenhaltungen:
- DE-A1-102005 025 125
- STANGL R ET AL: "Planar rear emitter back contact silicon heterojunction solar cells", SOLAR ENERGY MATERIALS AND SOLAR CELLS, ELSEVIER SCIENCE PUBLISHERS, AMSTERDAM, NL, Bd. 93, Nr. 10, 1. Oktober 2009 (2009-10-01), Seiten 1900-1903, XP002577678, ISSN: 0927-0248, DOI: 10.1016/J.SOLMAT.2009.06.010 [gefunden am 2009-07-11]
- LU M ET AL: "a-Si/c-Si heterojunction for interdigitated back contact solar cell", PROCEEDINGS OF THE 22ND EUROPEAN PHOTOVOLTAIC SOLAR ENERGY CONFERENCE, 3. September 2007 (2007-09-03), - 7. September 2007 (2007-09-07), Seiten 924-927, XP040513137, ISBN: 978-3-936338-22-5
- TAGUCHI M ET AL: "Obtaining a higher Voc in HIT cells", PROGRESS IN PHOTOVOLTAICS. RESEARCH AND APPLICATIONS, JOHN WILEY AND SONS, CHICHESTER, GB, Bd. 13, Nr. 6, 1. September 2005 (2005-09-01), Seiten 481-488, XP002595700, ISSN: 1062-7995, DOI: 10.1002/PIP.646
- SCHMIDT J ET AL: "Atomic-layer-deposited aluminum oxide for the surface passivation of high-efficiency silicon solar cells", 2008 33RD IEEE PHOTOVOLTAIC SPECIALISTS CONFERENCE: PVSC; SAN DIEGO, CALIFORNIA, USA; 11 - 16 MAY 2008, IEEE, PISCATAWAY, NJ, Bd. 33, 11. Mai 2008 (2008-05-11), Seiten 1-5, XP002628726, DOI: 10.1109/PVSC.2008.4922636 ISBN: 978-1-4244-1640-0 in der Anmeldung erwähnt

## Beschreibung

Die Erfindung bezieht sich auf eine rückseitenkontaktierte Solarzelle zumindest mit
- einer Absorberschicht und einer rückseitig angeordneten Emitterschicht aus Halbleitermaterialien gegensätzlicher p- und n-typ Dotierung,
- einem zwischen der Absorberschicht und der Emitterschicht angeordneten metallischen Kontaktgitter, das gegenüber der Emitterschicht durch ein kongruentes Isolationsgitter elektrisch isoliert ist, zur Sammlung von durch Lichteinfall in der Absorberschicht erzeugten überschüssigen Majoritätsladungsträgern, wobei die Sammlung unterstützt ist und wobei Isolationselemente des Isolationsgitters eine seitliche Überdeckungsbreite L über Kontaktelemente des Kontaktgitters haben,
- einer rückseitig auf der Emitterschicht angeordneten Kontaktfläche zur Sammlung von durch Lichteinfall in der Absorberschicht erzeugten überschüssigen Minoritätsladungsträgern
   und
- einer rückseitig angeordneten, unstrukturierten intrinsisch leitfähigen Passivierschicht, die zumindest zwischen den Kontaktelementen unmittelbar auf der Absorberschicht angeordnet ist.

Bei rückseitenkontaktierten Solarzellen liegen beide Kontaktierungen zur Einsammlung der überschüssigen Majoritäts- und Minoritäts-Ladungsträger auf der Rückseite, also auf der im Betriebsfall lichtabgewandten Rückseite der Solarzelle. Dadurch treten keine Abschattungsverluste durch eine vorderseitig, also auf der im Betriebsfall lichtzugewandten Vorderseite der Solarzelle, angebrachte Kontaktierung, die in der Regel mit einem flächenminimierten Kontaktgitter zusammen arbeitet, auf. Es ergibt sich bei der Rückseitenkontaktierung dementsprechend ein vergleichsweise hohes Kurzschlussstrom-Potenzial. Jedoch steigt der Strukturierungsaufwand von rückseitenkontaktierten Solarzellen im Vergleich zu beidseitig, d.h. vorderseitig und rückseitig, kontaktierten Solarzellen stark an. Dies gilt insbesondere dann, wenn konventionell diffundierte Homo-Kontakte zur selektiven Ladungsträgertrennung eingesetzt werden (Halbleiter-Halbleiter-Kontakte mit gleichem Bandabstand, Ausbildung z.B. von Homo n+/p und p+/p Emitter- bzw. BSF-Bereichen).

In diesem Zusammenhang sind die verwendeten Begriffe "Kontakt" oder "Kontaktierung" nicht im Sinne des metallischen Kontaktsystems, sondern im Sinne einer "Kontaktbildung" zwischen den unterschiedlichen Halbleitermaterialien zu verstehen. Die Kontakte dienen der Ladungsträgertrennung. Zur Ladungsträgerableitung sind diese Kontakte dann mit dem entsprechenden Kontaktsystem verbunden. Bei den Kontakten sind Homo-Kontakte (Diffusion) und Hetero-Kontakte (getrennte Schichten) zu unterscheiden. Weiterhin ist der Begriff der "Unstrukturiertheit" im Sinne von Schichtdurchgängigkeit, also völliges Fehlen von Öffnungen in der Schicht, durch die die darunter liegende Schicht beeinträchtigt wird, zu verstehen und nicht im Sinne einer Anpassung des Formverlaufs der Schicht an die darunter liegenden Schichten bzw. Elemente.

Bei Homo-Kontakten sind mehrere Maskierungsschritte für die Ausbildung von rückseitig angeordneten diffundierten stark p- bzw. stark n-dotierten Bereichen innerhalb der Absorberschicht der Solarzelle erforderlich. Zudem ist die Kontaktrekombination - am Kontakt Kontaktsystem/n+/Absorberschicht bzw. Kontaktsystem/p+/Absorberschicht mit n+/p+ als hochdotiertem rückseitigem Oberflächenfeld BSF - bei einer Homo-Kontaktierung immer vergleichsweise hoch, so dass Punktkontakte eingesetzt werden müssen, um den Anteil der Kontaktrekombination zu minimieren. Dies erhöht jedoch wiederum den erforderlichen Aufwand an Strukturierung.

Werden anstelle von diffundierten Homo-Kontakten getrennte Hetero-Kontakte zur selektiven Ladungsträgertrennung verwendet (Halbleiter/Halbleiter-Kontakte mit unterschiedlichem Bandabstand, Ausbildung z.B. von Heteron+/p und p+/p -Emitter bzw. BSF-Bereichen, hierbei werden z.B. über plasmagestützte Gasphasenabscheidung erzeugte Heteroschichten von außen auf den Solarzellen-Absorber aufgebracht), so kann aufgrund der bei einer Hetero-Kontaktierung vorhandenen Band-Offsets die Kontaktrekombination erheblich herabgesetzt werden. Bei vergleichbarem Strukturierungsaufwand im Vergleich zur Homo-Kontaktierung ergibt sich somit bei einer Hetero-Kontaktierung aufgrund der reduzieren Kontaktrekombination ein höheres offenes Klemmspannungs-Potenzial.

### STAND DER TECHNIK

Aus der DE 41 43 083 A1 ist eine rückseitenkontaktierte Solarzelle bekannt, bei der die Kontakte alternierend auf Erhebungen angeordnet sind, wobei die Erhebungen zumindest bereichsweise zuvor mit einer Passivierschicht abgedeckt und anschließend abschnittsweise zur Anbringung der Kontakte von dieser wieder freigelegt wurden. Somit sind die Kontakte direkt auf der Absorberschicht angeordnet und es tritt hohe Kontaktrekombination auf.

Aus der EP 1 873 840 A1 ist eine rückseitenkontaktierte Solarzelle mit interdigitierenden Kontakten bekannt. Zwischen den Kontakten und der Absorberschicht sind graduiert dotierte intrinsische Schichtbereiche angeordnet. Durch die Verschachtelung der Kontakte ist die Absorberschicht aber im Bereich der Isolationsgräben weiterhin strukturiert.

Aus der US 2008/0121279 A1 ist eine rückseitenkontaktierte Solarzelle mit einem undotierten oder leicht dotierten Substrat als unstrukturierte Absorberschicht und rückseitig angeordneten, alternierenden p- und n-dotierten Bereichen bekannt. Diese sind als so genannte "Nanoemitter" ausgebildet, d.h. hoch n- bzw. p-dotierte Silizium-Nanopartikel, die in eine Silizium-Oxidschicht eingebettet sind. Die Silizium-Oxidschicht ist zwar elektrisch nichtleitend, aber aufgrund ihrer zu wählenden geringen Dicke für Ladungsträger durchtunnelbar. Sie dient gleichzeitig der Passivierung des unstrukturierten Substrats. Die ladungsträger-trennenden Felder werden somit von leitenden Emitter- bzw. BSF-Schichten (p-Emitter, n-Emitter) erzeugt, ebenso werden die überschüssigen Ladungsträger über (dotierte) Emitter- bzw. BSF-Schichten abgeleitet. Der Einsatz einer dünnen Silizium-Oxidschicht als passivierende Tunnelbarriere macht von einem anderen physikalischen Prinzip Gebrauch als eine intrinsisch leitfähige Passivierschicht, bei der es sich um eine Halbleiter-Schicht handelt, die einen zusätzlichen Serienwiderstand in die Zelle einbringt, der nur linear mit der Schichtdicke wächst. Demgegenüber ist die Silizium-Oxidschicht ein Isolator, der nur für sehr geringe Schichtdicken aufgrund des Tunneleffekts von einem Strom durchflossen werden kann. Der Tunnelstrom fällt - d.h. der Serienwiderstand steigt - exponentiell mit der Schichtdicke der Siliziumoxid-Tunnelbarriere. Dies macht eine extrem genaue Kontrolle der Schichtdicke der Silizium-Oxidschicht erforderlich und bedingt eine hohe Reinheit bei der Prozessierung, weil beim Wachstum der nur wenige Angström dünnen Tunnelbarriere Verunreinigungen auf der Absorberoberfläche zu Kurzschlüssen und dem Verlust der Passivierwirkung führen. Weiterhin erfordert die Kontaktierung der Nanoemitter einen entsprechenden Strukturierungsaufwand, bei dem auf die gegenseitige Isolation der beiden Kontaktsysteme zu achten ist. Dies bedingt einen erhöhten Aufwand bei der exakten Anordnung der in aufeinanderfolgenden Prozessschritten hergestellten Masken, da sonst Kurzschlüsse zwischen den p- und n-Emitter-Bereichen entstehen würden. Schließlich wird in der US 2008/0121279 A1 in üblicher Weise Gebrauch von n- bzw. p-dotierten Halbleiterschichten gemacht, um den Kontakt für die beiden Ladungsträger-Typen auszubilden.

Passivierschichten reduzieren die Oberflächen-Rekombinations-Geschwindigkeit der Absorberschicht. Sie können leitend (z.B. intrinsisches oder dotiertes hydrogenisiertes amorphes Silizium, a-Si:H) oder nichtleitend ausgebildet sein (z.B. Oxide, Nitride). Die meisten Passivierschichten funktionieren hauptsächlich durch eine Absättigung (Reduzierung) der Oberflächen-Defekte des Photoabsorbers (z.B. ein thermisch gewachsenes Oxid auf einem Siliziumwafer durch Absättigung der offenen "Dangling-Bonds"). Es ist jedoch auch möglich, eine geringe Oberflächen-Rekombinations-Geschwindigkeit über eine sehr hohe Oberflächenladung innerhalb der Passivierschicht zu erzielen. Die Oberflächenladung der Passivierschicht führt dann ebenfalls zu einer Ausbildung einer Raumladungszone im Photoabsorber. Ist die Oberflächenladung sehr hoch, so kann die resultierende Bandverbiegung des Absorbers bis in die Entartung oder nahe an die Entartung getrieben werden (vollständige Bandverbiegung, die Valenzband- bzw. die Leitungsband-Kante berührt dann an der Oberfläche des Halbleiters das Fermi-Energieniveau des Halbleiters). Die Dichte einer Ladungsträgersorte ist dann lokal an der Halbleiter-Oberfläche stark erhöht. Dort steht dann - je nach eingesetztem Material - jeweils nur eine Sorte photogenerierter Überschuss-Ladungsträger (entweder nur Überschuss-Elektronen oder nur Überschuss-Löcher, äquivalent "eine Polarität" und "entgegengesetzte Polarität") zur Verfügung, so dass trotz einer eventuell vorhandenen hohen Oberflächen-Defektdichte keine Oberflächen-Rekombination möglich ist. Bekannte Beispiele solcher Passivierschichten sind z.B. über plasmagestützte chemische Gasphasenabscheidung (PECVD) auf Silizium abgeschiedenes Siliziumnitrid (SiN (Akronym, nicht stöchiometrische Formel), sehr hohe positive Oberflächenladung) oder über "atomic layer deposition" (ALD) auf Silizium abgeschiedenes Aluminiumoxid (AIO (Akronym, nicht stöchiometrische Formel), sehr hohe negative Oberflächenladung). Derartige Passivierschichten sind beispielsweise aus den beiden nachgenannten Veröffentlichungen bekannt.

Aus der VERÖFFENTLICHUNG I von Jan Benick et al.: "Surface passivation of boron diffused emitters for high efficiency solar cells" (Proceedings PVSEC-33, San Diego, Mai 2008) ist ebenfalls die Anwendung von Al₂O₃ als Passivierschicht für einen diffundierten (p+)-Emitter bekannt. Es wurde eine Solarzelle Al₂O₃ / cSi (p+, Frontemitter, flächig, diffundiert) / c-Si(n, Absorber, Wafer) / SiO₂ mit c-Si(n+, BSF, rückseitige Punktkontakte, diffundiert) mit einem Wirkungsgrad von 23,2% prozessiert. Aus der VERÖFFENTLICHUNG II von Jan Schmidt et al.: "Atomic-layer-deposited aluminium oxide for the surface passivation of high efficiency silicon solar cells" (Proceedings PVSEC-33, San Diego, Mai 2008) ist die Struktur einer prozessierten Solarzelle mit 20,6 % Wirkungsgrad (Siliziumnitrid / cSi(n+, Frontemitter, flächig, diffundiert) / c-Si(p, Absorber, Wafer) / Al₂O₃ mit c-Si(p+, BSF, rückseitige Punktkontakte, diffundiert). In beiden Veröffentlichungen gibt es die (diffundierten) (p+)- bzw. (n+)- Emitter- bzw. BSF-Bereiche, die dann (über die Ausbildung eines "konventionellen" p+/n bzw. n+/p Emitter-Kontakts an der Emitter-AbsorberGrenzfläche bzw. über die Ausbildung eines p+/p bzw. eines n+/n BSF-Kontakts an der BSF-Absorber-Grenzfläche) die selektive "konventionelle" Ladungsträgertrennung ermöglichen.

Der nächstliegende Stand der Technik, von dem die vorliegende Erfindung ausgeht, wird in der DE 10 2005 025 125 B4 und in der Veröffentlichung von Rolf Stangl et al.: "Planar rear emitter back contact silicon heterojunction cells" (Solar Energy Materials & Solar Cells 93 (2009) 1900-1903) offenbart. Beschrieben wird eine gattungsgemäße rückseitenkontaktierte Solarzelle zumindest mit einer Absorberschicht und einer rückseitig angeordneten Emitterschicht aus Halbleitermaterialien gegensätzlicher p- und n-typ Dotierung. Rückseitig auf der Emitterschicht, d.h. auf der von der Absorberschicht abgewandten Seite der Emitterschicht, ist eine durchgängige Kontaktfläche als Kontaktsystem zur Sammlung von durch Lichteinfall in der Absorberschicht erzeugten überschüssigen Minoritätsladungsträgern angeordnet. Die überschüssigen Majoritätsladungsträger werden aus der Absorberschicht direkt über ein metallisches Kontaktgitter als Kontaktsystem abgeleitet, das zwischen der Absorberschicht und der Emitterschicht angeordnet und gegenüber der Emitterschicht mittels eines kongruenten, d.h. deckungsgleichen Isolationsgitters elektrisch isoliert ist. Weiterhin ist bei der gattungsgemäßen Solarzelle eine unstrukturierte intrinsisch leitfähige Passivierschicht rückseitig vorgesehen, die der Passivierung der Grenzfläche (pn-Übergang) zwischen Absorberschicht und Emitterschicht dient. Des Weiteren hat die Passivierschicht auch die Funktion einer Pufferschicht, die der Aufweitung des pn-Übergangs dient. Die Passivierschicht wird aufgebracht, nachdem das Kontaktgitter mit dem Isolationsgitter abgedeckt ist, dabei haben Isolationselemente des Isolationsgitters eine seitliche Überdeckungsbreite L über Kontaktelemente des Kontaktgitters. Die Passivierschicht liegt also nur zwischen den einzelnen Kontaktierungselementen (punkt- oder streifenförmig) des Kontaktsystems direkt auf der Absorberschicht auf und passiviert diese. Im Bereich des Kontaktgitters liegt die Passivierschicht auf dem Isolationsgitter und hat keinen Kontakt zur Absorberschicht. Vielmehr kontaktiert das Kontaktgitter direkt die Absorberschicht. Unterhalb des Kontaktgitters sind in die Absorberschicht diffundierte, die Sammlung von überschüssigen Majoritätsladungsträgern unterstützende BSF-Bereiche angeordnet, weshalb es sich um einen diffundierten Homo-Kontakt mit einer vergleichsweise hohen Kontaktrekombination handelt. Die technologische Strukturierung des die überschüssigen Majoritäts-Ladungsträger abführenden Kontaktgitters in Form der Isolierung durch das Isolationsgitter (ganzflächiges Aufbringen der Isolationsschicht und anschließendes Abätzen im Bereich der Absorberschicht, damit nur oberhalb des Kontaktgitters eine Abdeckung zurückbleibt) schädigt jedoch in der Regel erheblich die Grenzfläche der Absorberschicht. Außerdem kann diese im Anschluss ohne eine Schädigung des Isolationsgitters nicht ausreichend aggressiv gereinigt werden. Die bekannte Solarzelle weist also eine gemischte Homo-Hetero-Kontaktierung auf, bei der die Majoritätsladungsträger aus der Absorberschicht über einen Homo-Kontakt (diffundierter BSF-Bereich) und nur die Minoritätsladungsträger aus der Absorberschicht über eine Hetero-Kontaktierung (getrennte Emitterschicht) ausgeführt ist.

Grundsätzlich ist jedoch bei einer Hetero-Kontaktierung durch die Emitterschicht die Ausbildung einer gut passivierten Grenzfläche der Absorberschicht zur Emitterschicht von entscheidender Bedeutung. Üblicherweise werden zur Passivierung der Absorber-Grenzfläche ultradünne, intrinsisch-leitfähige Passivierschichten (z.B. intrinsisches a-Si:H) als Pufferschichten zwischen dem Solarzellen-Absorber (z.B. ein c-Si Wafer) und der Heterokontaktschicht (z.B. dotiertes a-Si:H) eingesetzt. Allerdings ist bis dato eine gut passivierende Strukturierung der Absorbergrenzfläche technologisch äußerst schwierig zu realisieren, die Grenzfläche des Absorbers wird aufgrund der Strukturierung in der Regel erheblich geschädigt, obwohl sie sich z.B. über eine intrinsisch-leitfähige Pufferschicht zunächst flächig gut passivieren ließ.

### AUFGABENSTELLUNG

Die AUFGABE für die vorliegende Erfindung ist darin zu sehen, die eingangs beschriebene gattungsgemäße rückseitenkontaktierte Solarzelle so weiterzubilden, dass sie eine möglichst geringe Kontaktrekombination an beiden Kontakten im Zusammenhang mit einer besonders guten Grenzflächenpassivierung der Absorberschicht und einer effizienten Ladungsträgerausbeute aufweist. Die erfindungsgemäße LÖSUNG für diese Aufgabe ist dem Hauptanspruch zu entnehmen, vorteilhafte Weiterbildungen der Erfindung werden in den Unteransprüchen aufgezeigt und im Folgenden im Zusammenhang mit der Erfindung näher erläutert.

Bei der erfindungsgemäßen rückseitigen Solarzelle ist eine vollflächige Anordnung der unstrukturierten, intrinsisch leitfähigen Passivierschicht, die rückseitig angeordnet ist, unmittelbar, d.h. direkt auf der gesamten Absorberschicht vorgesehen. Dadurch ist die Absorberschicht an der pn-Grenzfläche zur Emitterschicht gut passiviert. Dabei macht die intrinsisch leitfähige Passivierschicht von einem anderen physikalischen Prinzip Gebrauch als die oben erwähnte elektrisch nicht-leitende Silizium-Oxidschicht mit der Funktion einer Tunnelbarriere. Bei der intrinsisch leitfähigen Passivierschicht handelt es sich um eine Halbleiter-Schicht, die einen zusätzlichen Serienwiderstand in die Zelle einbringt, der nur linear mit der Schichtdicke wächst. Die durch die intrinsisch leitfähige Passivierschicht erreichte gute Passivierung der Absorberschicht wird auch nicht wieder aufgehoben oder beeinträchtigt, da die Absorberschicht bei der erfindungsgemäßen Solarzelle völlig unstrukturiert ist. Somit können keine Strukturierungsmaßnahmen, wie direktes Kontaktieren durch eindiffundierte Homo-Kontakte, Strukturieren der angrenzenden Schichten und von Kontaktelementen oder Reinigungs- und Ätzschritte bis herunter auf die Absorberschicht, die Absorberschicht nachteilig beeinträchtigen. Ein Entfernen der Passivierschicht im Bereich des Kontaktgitters zur Ableitung der überschüssigen Majoritäts-Ladungsträger ist bei der Erfindung vermieden. Vielmehr ist das Kontaktgitter unmittelbar, d.h. direkt auf der intrinsisch leitfähigen Passivierschicht angeordnet. Durch die Kontaktvermeidung zwischen Kontaktgitter und Absorberschicht und damit durch das Entfallen von diffundierten BSF-Bereichen unterhalb des Kontaktgitters erfolgt auch die Ableitung der überschüssigen Majoritäts-Ladungsträger bei der Erfindung über eine Hetero-Kontaktierung. Zusammen mit der beibehaltenen Ableitung der überschüssigen Minoritäts-Ladungsträger über einen rekombinationsarmen Heterokontakt ist somit bei der Erfindung eine reine Hetero-Kontaktierung umgesetzt, sodass sich die auftretende Kontaktrekombination bei der Solarzelle nach der Erfindung drastisch verringert.

Dabei ergibt sich trotzdem eine hohe Effizienz bei der getrennten Ladungsträgersammlung, da die Passivierschicht intrinsisch elektrisch leitfähig ist. Eine intrinsische Leitfähigkeit entsteht dadurch, dass Festkörper von sich aus, d.h. intrinsisch dazu neigen, Gitterfehler auszubilden und damit eine Ladungsbewegung ("elektrische Leitfähigkeit") ermöglichen. In amorphen Halbleitermaterialien wirken aufgebrochene Bindungen (dangling bonds) und verspannte Bindungen (strained bonds) ähnlich wie Gitterfehler in einem kristallinen Festkörper. Sie sind thermodynamisch begünstigt, da sie einen Entropiegewinn bringen. Das System neigt demnach bis zu einem gewissen Grad dazu Defekte auszubilden. Diese Fehler werden als intrinsische Fehler bezeichnet. Die Defektkonzentration ist temperaturabhängig. Sie steigt mit der Temperatur und hat bei 0 K den Wert null. Intrinsische Defekte sorgen folglich bei Temperaturen > 0 K für bewegliche Ladungen und damit für eine intrinsische Leitfähigkeit.

Erforderlich ist auch bei der Erfindung die elektrisch isolierende Abdeckung des Kontaktgitters zur Emitterschicht hin mittels des mit dem Kontaktgitter kongruenten Isolationsgitters. Die isolierende Abdeckung wird bislang beispielsweise durch ganzflächiges Auftragen einer Schicht und partielles Wegätzen bis auf die Absorbergrenzfläche erzeugt. Hierbei kommt es aber bei der Erfindung nicht mehr zu einer Schädigung der Absorbergrenzfläche, da diese durch die geschlossene intrinsisch leitfähige Passivierschicht durchgängig geschützt ist. Eine Schädigung der Oberfläche der Passivierschicht bei der Erzeugung des Isolationsgitters ist dagegen verhältnismäßig unproblematisch, da hierauf ohnehin die defektreiche Emitterschicht abgeschieden wird.

Um eine besonders effiziente Hetero-Kontaktierung zu ermöglichen, wird bei der erfindungsgemäßen Solarzelle zusätzlich die Akkumulation der überschüssigen Majoritätsladungsträger und Abstoßung der überschüssigen Minoritätsladungsträger aus der Absorberschicht im Bereich des Kontaktgitters gezielt unterstützt. Dies erfolgt erfindungsgemäß zum einen durch eine Ausbildung des Isolationsgitters aus einem nicht dotierten, elektrisch isolierenden Passiviermaterial hoher Oberflächenladung mit zur Dotierung der Absorberschicht entgegengesetzter Polarität, wobei die Oberflächenladung so hoch ist, dass eine Entartung an der Oberfläche der Absorberschicht resultiert (z.B. Siliziumnitrid (Akronym SiN), ein Material mit hoher positiver Oberflächenladung im Falle einer n-dotierten Absorberschicht, oder z.B. Aluminiumoxid (Akronym AlO), ein Material mit hoher negativer Oberflächenladung im Falle einer p-dotierten Absorberschicht). Aufgrund der Oberflächenladung der isolierenden Passivierschicht bildet sich eine Raumladungszone in der Absorberschicht in den Bereichen unterhalb der elektrisch isolierenden Passivierschicht aus, die die überschüssigen Majoritätsladungsträger in der Absorberschicht akkumuliert und die überschüssigen Minoritätsladungsträger abstößt. Dies ermöglicht die selektive Ladungsträgertrennung und Abführung der überschüssigen Majoritätsladungsträger aus der Absorberschicht über die intrinsisch-leitfähige Hetero-Passivierschicht (analog zu einer BSF-Schicht). Geeignetes Passiviermaterial zur Ausbildung des Isolationsgitters wurde bereits im Stand der Technik aufgezeigt und in seinen Eigenschaften erläutert.

Als weitere Maßnahme für eine besonders effiziente Hetero-Kontaktierung wird bei der Erfindung das Kontaktgitter aus einem Metall mit einer die Akkumulation und Abstoßung unterstützenden Potenzialbarriere zur intrinsisch leitfähigen Passivierschicht ausgebildet. Dadurch wird noch zusätzlich die selektive Ladungsträgertrennung und Abführung der überschüssigen Majoritätsladungsträger aus der Absorberschicht über die intrinsisch-leitfähige Hetero-Passivierschicht - analog zu einer BSF Schicht - unterstützt. Bevorzugte Maßnahmen zur Erzeugung einer geeigneten Potenzialbarriere werden weiter unten bei den vorteilhaften Modifikationsmöglichkeiten der Solarzelle nach der Erfindung aufgezeigt. Somit wird bei der Erfindung gegenüber dem üblichen Gebrauch von n- bzw. p-dotierten Halbleiterschichten zur Ausbildung von Kontakt für die beiden Ladungsträger-Typen der Kontakt für die Majoritätsladungsträger durch ein Metall geeigneter Austrittsarbeit, ggf. in Kombination mit einer Isolationsschicht mit hoher Festladung, ausgebildet. Ein solcher Kontakt ist also kein p/n-Halbleiterkontakt, sondern ein Feldeffekt-Kontakt, ähnlich wie in MOS-Feldeffekt-Bauelementen der Mikroelektronik.

Schließlich ist bei der erfindungsgemäßen Solarzelle noch eine solche Überdeckungsbreite L von Isolationselementen (Isolationsstege oder Isolationspunkte) des Isolationsgitters auf den Kontaktelementen (Kontaktstege oder Kontaktpunkte) des Kontaktgitters vorgesehen, dass ein innerer Zellkurzschluss von den metallischen Kontaktelementen des Kontaktgitters in die intrinsisch-leitfähige Hetero-Passivierschicht unterhalb des Isolationsgitters bis hin zur Hetero-Emitterschicht aufgrund des hohen Serienwiderstands der ultradünnen intrinsisch leitfähigen Hetero-Passivierschicht ausgeschlossen ist. Überschüssige Minoritätsladungsträger aus der Absorberschicht werden somit sicher über die Emitterschicht und die Kontaktfläche abgeleitet und wandern nicht (wie im Kurzschlussfall) zum Kontaktgitter, das der Sammlung der Majoritätsladungsträger aus der Absorberschicht dient. Beispielsweise kann eine ca. 30 µm breite Stegbreite des Isolationsgitters bei einer 10 nm dicken intrinsischen a-Si:H Schicht als intrinsisch leitfähige Passivierschicht gewählt werden.

Die entscheidenden Vorteile der rückseitenkontaktierten Solarzelle mit unstrukturierter Absorberschicht und ausschließlicher Hetero-Kontaktierung nach der Erfindung bestehen zusammenfassend also insbesondere darin, dass
- der Strukturierungsaufwand im Vergleich zu anderen rückseitenkontaktierten Solarzellen mit gemischter Homo-Hetero-Kontaktierung äußerst gering ist,
- keine Ausrichtungsprobleme (Alignment) im Vergleich zu anderen rückseitenkontaktierten Solarzellen mit gemischter Homo-Hetero-Kontaktierung bestehen,
- es sich um eine reine Hetero-Kontaktierung mit einer gegenüber dem Stand der Technik deutlich geringeren Kontaktrekombination handelt, da nunmehr beide Ladungsträger sammelnden Kontakte als Heterokontakte ausgeführt sind ("Feldeffekt-Kontakte"), und
- die Strukturierung des zum Kontaktgitter kongruenten Isolationsgitters keine Grenzflächenstrukturierung der Absorberschicht bedingt und somit insbesondere keine Oberflächenschädigung der Absorberschicht bewirkt.

Vorteilhaft kann bei der Solarzelle nach der Erfindung die Absorberschicht sowohl als Dickschicht in Form eines Wafers oder als Dünnschicht auf einem Substrat (keine Lichtdurchstrahlung, d.h. rückseitige Anordnung) oder Superstrat (Lichtdurchstrahlung, d.h. vorderseitige Ausbildung) ausgebildet sein. Weiterhin kann das Kontaktgitter vorteilhaft mit streifenförmigen oder punktförmigen Kontaktelementen ausgebildet sein. In einer weiteren vorteilhaften Modifikation der Solarzelle nach der Erfindung ist vorderseitig zusätzlich eine unstrukturierte, elektrisch isolierende Passivierschicht zur Absättigung der Oberflächendefekte und damit Verbesserung der Ladungsträgerausbeute vorgesehen.

Weiterhin kann bei der Solarzelle nach der Erfindung die die Akkumulation und Abstoßung unterstützende Potenzialbarriere des metallischen Kontaktgitters zur intrinsisch leitfähigen Passivierschicht vorteilhaft durch ein Kontaktgitter aus einem Metall mit einer die Akkumulation und die Abstoßung unterstützenden Austrittsarbeit erzeugt werden. Alternativ kann aber auch vorteilhaft die Akkumulation der überschüssigen Majoritätsladungsträger und die Abstoßung der überschüssigen Minoritätsladungsträger unterstützende, intrinsisch leitfähige Passivierschicht mit Oberflächendipolen vorgesehen sein, wobei die Oberflächendipole durch chemische Oberflächenvorbehandlung erzeugt sind und deren Anordnung vor der Metallisierung, d.h. der Erzeugung des Kontaktgitters, erfolgt. Weiterhin kann bei der Erfindung bei einer p-typ dotierten Absorberschicht vorteilhaft eine Ausbildung des Isolationsgitters aus Aluminiumoxid als nicht dotiertem, elektrisch isolierendem Passiviermaterial hoher negativer Oberflächenladung vorgesehen sein. Bei einer n-typ dotierten Absorberschicht kann das Isolationsgitter bevorzugt aus Siliziumnitrid als nicht dotiertem, elektrisch isolierendem Passiviermaterial hoher positiver Oberflächenladung bestehen. Weiterhin können bei der Erfindung die Absorberschicht und die Emitterschicht bevorzugt aus Silizium, die leitfähige Passivierschicht aus intrinsischem, amorphem Silizium und das Kontaktgitter und die Kontaktfläche aus Aluminium bestehen. Weitere Einzelheiten zur Erfindung sind den nachfolgenden Ausführungsbeispielen zu entnehmen.

### AUSFÜHRUHGSBEISPIELE

Ausbildungsformen der rückseitenkontaktierten Solarzelle mit unstrukturierter Absorberschicht und ausschließlicher Hetero-Kontaktierung nach der Erfindung werden nachfolgend anhand der schematischen Figuren zum weiteren Verständnis der Erfindung näher erläutert. Dabei zeigt:
- **FIGUR 1**: eine waferbasierte Solarzelle im schematischen Querschnitt,
- **FIGUR 2**: eine dünnschichtbasierte Solarzelle mit Superstrat im schematischen Querschnitt und
- **FIGUR 3**: die Solarzelle gemäß **FIGUR 1** oder **2** in einem schematischen Schnitt **AA.**

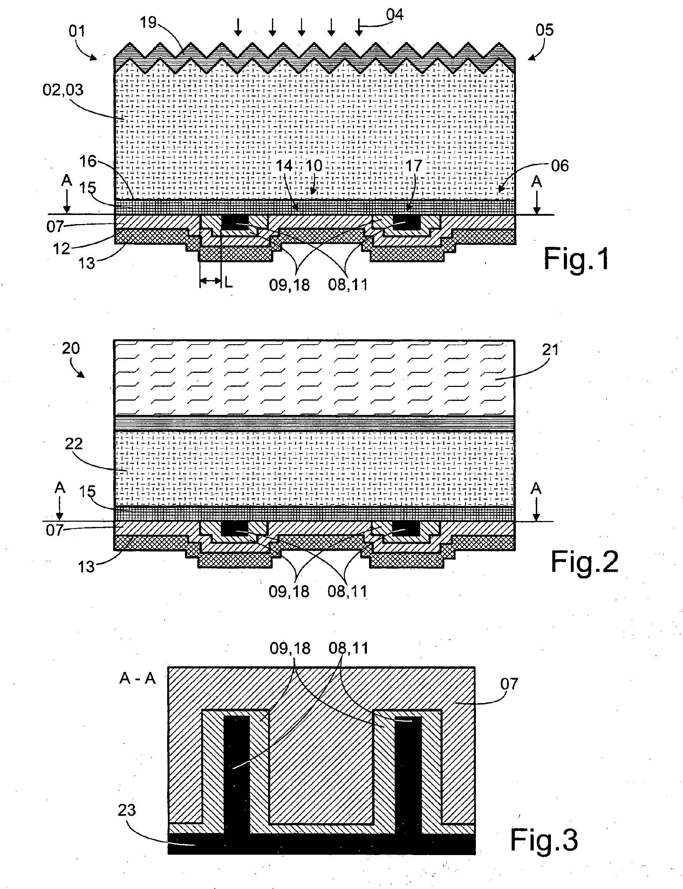

In der **FIGUR 1** ist eine rückseitenkontaktierte Solarzelle **01** im schematischen Querschnitt mit einer Absorberschicht **02** in Form eines Wafers **03** dargestellt. Der Lichteinfall **04** im Betrieb erfolgt von der Vorderseite **05** her. Auf der Rückseite **06** ist eine durchgängige, unstrukturierte Emitterschicht **07** angeordnet. Absorberschicht **02** und Emitterschicht **07** bestehen aus Halbleitermaterial, z.B. kristallinem Silizium, entgegengesetzter moderater Dotierung. Die Absorberschicht **02** ist beispielsweise p-dotiert (positiv dotiert), die Emitterschicht **07** ist dann entsprechend n-dotiert (negativ dotiert). Zwischen der Absorberschicht **02** und der Emitterschicht **07** ist ein metallisches Kontaktgitter **08** als Kontaktsystem zur Sammlung von durch den Lichteinfall **04** in der Absorberschicht **02** erzeugten überschüssigen Majoritätsladungsträgern angeordnet. Gegenüber der Emitterschicht **07** ist das metallische Kontaktgitter **08** durch ein kongruentes, d.h. deckungsgleiches Isolationsgitter **09** elektrisch isoliert. Das Isolationsgitter **09** bedeckt nur das Kontaktgitter **08**, sodass Bereiche **10** zwischen den Kontaktelementen **11** des Kontaktgitters **08** davon frei bleiben. Auf der Rückseite **12** der Emitterschicht **07** ist eine durchgängige, unstrukturierte Kontaktfläche **13** als Kontaktsystem zur Sammlung von durch Lichteinfall **04** in der Absorberschicht **02** erzeugten überschüssigen Minoritätsladungsträgern angeordnet. Deren Ableitung erfolgt somit über einen rekombinationsarmen äußeren Heterokontakt **14**, der in den Bereichen **10** entsteht.

Weiterhin ist bei der Solarzelle **01** nach der Erfindung auf der Rückseite **06** eine Passivierschicht **15** vorgesehen, die unstrukturiert und intrinsisch leitfähig ist und beispielsweise aus intrinsischem amorphem Silizium besteht. Diese Passivierschicht **15** ist bei der Erfindung vollflächig unmittelbar auf der gesamten Absorberschicht **02** angeordnet, die damit an ihrer Grenzfläche **16** zur Passivierschicht **15** unstrukturiert ausgebildet ist. Es ergeben sich somit keine Störungen an der Grenzfläche **16**. Das Kontaktgitter **08** ist auf der durchgängigen, intrinsisch leitfähigen Passivierschicht **15** angeordnet, sodass sich auch bei der Ableitung der Majoritätsladungsträger ein rekombinationsarmer innerer Heterokontakt 17 ergibt. In die Absorberschicht **02** diffundierte BSF-Bereiche entfallen vollständig. Beide Heterokontakte **14**, **17** sind dabei durch die intrinsisch leitfähige Passivierschicht **15** gut passiviert.

Zur Erzielung einer effektiven Ladungsträgertrennung und -ableitung ist bei der Solarzelle **01** nach der Erfindung eine zusätzliche Akkumulation der überschüssigen Majoritätsladungsträger und zusätzliche Abstoßung der überschüssigen Minoritätsladungsträger aus der Absorberschicht **02** im Bereich des Kontaktgitters vorgesehen. Dies erfolgt einerseits durch eine Ausbildung des Isolationsgitters **09** aus einem nicht dotierten, elektrisch isolierenden Passiviermaterial hoher Oberflächenladung mit zur Dotierung der Absorberschicht entgegengesetzter Polarität. Wenn die Absorberschicht **02** aus kristallinem p-dotierten Silizium besteht, kann das Isolationsgitter **09** aus Aluminiumoxid bestehen. Ist die Absorberschicht n-dotiert, kann Siliziumnitrid für das Isolationsgitter **09** gewählt werden. Andererseits werden Akkumulation und Abstoßung forciert durch eine Ausbildung des metallischen Kontaktgitters 08 mit einer unterstützenden Potenzialbarriere zur intrinsisch leitfähigen Passivierschicht **15**. Dabei kann die Potenzialbarriere durch eine entsprechende Metallwahl, beispielsweise Aluminium, oder durch eine Oberflächenvorbehandlung vor der Metallisierung zur Ausbildung von Oberflächendipolen aufgebaut werden.

Schließlich werden bei der Solarzelle **01** nach der Erfindung noch innere Zellkurzschlüsse sicher vermieden durch eine entsprechende Wahl der Überdeckungsbreite **L** von Isolationselementen **18** des Isolationsgitters **09**. Dabei beschreibt die Überdeckungsbreite L den seitlichen Überstand der Isolationselemente **18** über die Kontaktelemente **11.** Somit können keine Majoritätsladungsträger in der Emitterschicht **07** zu den Kontaktelementen **11** des Kontaktgitters **08** fließen, sondern werden zuverlässig über die Kontaktfläche **13** abgeleitet.

Zur Passivierung der Vorderseite **05** der Absorberschicht **02** ist im gewählten Ausführungsbeispiel noch eine elektrisch isolierende Passivierschicht **19**, beispielsweise aus Siliziumoxid oder Siliziumnitrid, vorgesehen. Diese kann zur Verringerung von Reflexionen zum Lichteinfall **04** hin texturiert (beispielsweise zickzackförmig) sein.

Die **FIGUR 2** zeigt einen zur **FIGUR 1** analogen Aufbau, hier fehlende Bezugszeichen sind der **FIGUR 1** zu entnehmen. Im Unterschied zu **FIGUR 1** ist jedoch eine Dünnschicht-Solarzelle **20** mit einem Superstrat **21**, beispielsweise aus Glas, gezeigt. Darauf befindet sich eine dünne Absorberschicht **22**.

Die **FIGUR 3** zeigt einen nicht maßstabsgerechten Schnitt **AA** der Solarzellen **01** aus **FIGUR 1** bzw. **20** aus **FIGUR 2**. Zu erkennen ist hier die streifenförmige Ausbildung der Kontaktelemente **11** des Kontaktgitters **08** und die seitliche Überdeckung durch die kongruenten Isolationselemente **18** des Isolationsgitters **09.** Weiterhin ist die Zusammenführung aller Kontaktelemente **11** in einem Randsteg **23** dargestellt.

**GEEIGNETE MATERIALIEN UND PARAMETER FÜR DIE SOLARZELLE NACH DER ERFINDUNG:**

| | |
|---|---|
| Absorberschicht | alle verwendeten Absorberschichten für Solarzellen, z.B. intrinsisches oder p- oder n- dotiertes kristallines Silizium, c-Si(i), c-Si(p), c-Si(n), intrinsisches oder p- oder n- dotiertes hydrogenisiertes, amorphes Silizium, a-Si:H(i), a-Si:H(p), a-Si:H(n), intrinsisches oder p- oder n-dotiertes mikrokristallines Silizium, µc-Si(i), µc-Si(p), µc-Si(n), intrinsisches oder p- oder n- dotiertes polykristallines Silizium, polyc-Si(i), polyc-Si(p), polyc-Si(n), CadmiumTellurid, CdTe, KupferlndiumSelenid, CISe, KupferIndiumGalliumSelenid, CIGSe, KupferIndiumSulfid, CIS |
| Isolationsgitter bei p-dotierter Absorberschicht | |
| | alle isolierenden Passivierschichten mit derart hoher negativen Oberflächenladung, dass eine Entartung an der Absorber-Oberfläche resultiert (bei waferbasierten c-Si Solarzellen mit intrinsischem Absorber entspricht dies etwa einer negativen Oberflächenladung > 10¹¹ cm⁻², bei waferbasierten c-Si Solarzellen mit p-dotiertem Absorber (z.B. Na=1,5·10¹⁶ cm⁻³) entspricht dies etwa einer negativen Oberflächenladung > 4·10¹² cm⁻²). Ein solches Material ist z.B. Aluminiumoxid Al₂O₃ (Oberflächenladung etwa 1,3·10¹³ cm⁻²). |
| Isolationsgitter bei n-dotierter Absorberschicht | |
| | alle elektrisch isolierenden Passivierschichten mit derart hoher positiven Oberflächenladung, dass eine Entartung an der Absorber-Oberfläche resultiert (bei waferbasierten c-Si Solarzellen mit intrinsischem Absorber entspräche dies etwa einer positiven Oberflächenladung > 10¹¹ cm⁻², bei waferbasierten c-Si Solarzellen mit p-dotiertem Absorber (z.B. Na=1,5·10¹⁶ cm⁻³) entspricht dies etwa einer positiven Oberflächenladung > 2·10¹² cm⁻²). Ein solches Material ist z.B. Siliziumnitrid, SiNₓ (Oberflächenladung etwa 2·10¹² cm⁻²). |
| | |
| elektrisch nicht-leitende Passivierschicht | |
| | SiO₂, Al₂O₃, SiNx, a-Si:H(i) |
| | |
| elektrisch leitende Passivierschicht | |
| | intrinsisches hydrogenisiertes, amorphes Silizium a-Si:H(i) |
| | |
| Dicke der elektrisch leitenden Passivierschicht | |
| | bevorzugt zwischen 5 nm und 10 nm |
| | |
| Emitterschicht | gegendotiert zur Absorberschicht: als Heterogenschicht abgeschiedenes p- oder n-dotiertes hydrogenisiertes amorphes Silizium, a-Si:H(p), a-Si:H(n), heterogen abgeschiedenes p-oder n- dotiertes mikrokristallines Silizium, µc-Si:H(p), µc-Si:H(n), p- oder n-dotiertes Silizium, c-Si(p), c-Si(n),heterogen abgeschiedenes Cadmiumsulfid, CdS, transparent leitfähige Oxide (ZnO, ITO, n-dötiert) |
| | |
| Kontaktelemente | Metalle, z.B. Aluminium, Molybdän, Chrom, Silber, Nickel, Titan, Palladium oder transparent leitfähige Oxide (ZnO, ITO) |
| | |
| Dicke der Absorberschicht bei waferbasierten c-Si Solarzellen | |
| | typischerweise zwischen 100 µm und 300 µm |
| | |
| Dicke der Absorberschicht bei Dünnschichtsolarzellen | |
| | typischerweise zwischen 500 nm und 10 µm |
| | |
| Überdeckungsbreite L der Isolationselemente neben den Kontaktelementen | |
| | bevorzugt zwischen 7 µm und 13 µm. |

Bei den vorstehend genannten Parameterwerten handelt es sich um typische oder bei der Erfindung bevorzugte Werte, die jedoch keinesfalls als beschränkend für die Erfindung anzusehen sind.

### BEZUGSZEICHENLISTE

- **01**: rückseitenkontaktierte Solarzelle mit 03
- **02**: Absorberschicht (Dickschicht) in Form eines Wafers
- **03**: Wafer
- **04**: Lichteinfall
- **05**: Vorderseite von 01
- **06**: Rückseite von 01
- **07**: Emitterschicht
- **08**: Kontaktgitter
- **09**: Isolationsgitter
- **10**: Bereiche
- **11**: Kontaktelement von 08
- **12**: Rückseite von 07
- **13**: Kontaktfläche
- **14**: äußerer Heterokontakt
- **15**: Passivierschicht (intrinsisch elektrisch leitfähig)
- **16**: Grenzfläche
- **17**: innerer Heterokontakt
- **18**: Isolationselement von 09
- **19**: Passivierschicht (elektrisch isolierend)
- **20**: rückseitenkontaktierte Solarzelle mit 21
- **21**: Superstrat
- **22**: Absorberschicht (Dünnschicht)
- **23**: Randsteg

- **L**: Überdeckungsbreite 18 neben 11

## Patentansprüche

1. Rückseitenkontaktierte Solarzelle (01, 20) zumindest mit
• einer Absorberschicht (02, 22) und einer rückseitig angeordneten Emitterschicht (07) aus Halbleitermaterialien gegensätzlicher p- und n-typ Dotierung,
• einem zwischen der Absorberschicht (02, 22) und der Emitterschicht (07) angeordneten metallischen Kontaktgitter (08), das gegenüber der Emitterschicht (07) durch ein kongruentes Isolationsgitter (09) elektrisch isoliert ist, zur Sammlung von durch Lichteinfall in der Absorberschicht (02, 22) erzeugten überschüssigen Majoritätsladungsträgern, wobei Isolationselemente (18) des Isolationsgitters (09) eine seitliche Überdeckungsbreite (L) über Kontaktelemente (11) des Kontaktgitters (08) haben,
• einer rückseitig auf der Emitterschicht (07) angeordneten durchgängigen Kontaktfläche (13) zur Sammlung von durch Lichteinfall in der Absorberschicht (02, 22) erzeugten überschüssigen Minoritätsladungsträgern und
• einer rückseitig angeordneten, unstrukturierten intrinsisch leitfähigen Passivierschicht (15), die zumindest zwischen den einzelnen Kontaktelementen (11) unmittelbar auf der Absorberschicht (02, 22) angeordnet ist,
• eine Akkumulation der überschüssigen Majoritätsladungsträger und Abstoßung der überschüssigen Minoritätsladungsträger aus der Absorberschicht (02, 22) im Bereich des Kontaktgitters (08) durch
• eine Ausbildung des Isolationsgitters (09) aus einem nicht dotierten, elektrisch isolierenden Passiviermaterial hoher Oberflächenladung mit zur Dotierung der Absorberschicht (02, 22) entgegengesetzter Polarität, wobei die Oberflächenladung so hoch ist, dass eine Entartung an der Oberfläche der Absorberschicht (2, 22) resultiert, und
• eine Ausbildung des metallischen Kontaktgitters (08) mit einer die Akkumulation und Abstoßung unterstützenden Potenzialbarriere zur intrinsisch leitfähigen Passivierschicht (15),
• eine solche seitliche Überdeckungsbreite (L) der Isolationselemente (18) des Isolationsgitters (09) über die Kontaktelemente (11) des Kontaktgitters (08), dass keine Majoritätsladungsträger aus der Emitterschicht (07) zu den Kontaktelementen (11) des Kontaktgitters (08) fließen können,
**GEKENNZEICHNET DURCH**
• eine vollflächige Anordnung der intrinsisch leitfähigen Passivierschicht (15) unmittelbar auf der gesamten Absorberschicht (02, 22), die an ihrer Grenzfläche (16) zur intrinsisch leitfähigen Passivierschicht (15) unstrukturiert ausgebildet ist,
• eine unmittelbare Anordnung des Kontaktgitters (08) auf der intrinsisch leitfähigen Passivierschicht (15).

2. Rückseitenkontaktierte Solarzelle nach Anspruch 1,
**GEKENNZEICHNET DURCH**
eine Ausbildung mit einem Wafers (03) als Absorberschicht (02) oder mit einem Superstrat (21) oder Substrat, auf das die Absorberschicht (22) als Dünnschicht aufgebracht ist.

3. Rückseitenkontaktierte Solarzelle nach Anspruch 1,
**GEKENNZEICHNET DURCH**
eine Ausbildung des Kontaktgitters (08) mit streifen- oder punktförmigen Kontaktelementen (11).

4. Rückseitenkontaktierte Solarzelle nach Anspruch 1,
**GEKENNZEICHET DURCH**
eine vorderseitig angeordnete unstrukturterte, elektrisch isolierende Passivierschicht (19).

5. Rückseitenkontaktierte Solarzelle nach Anspruch 1,
**GEKENNZEICHNET DURCH**
ein Kontaktgitter (08) aus einem Metall mit einer die Akkumulation der überschüssigen Majoritätsladungsträger und die Abstoßung der überschüssigen Minoritätsladungsträger unterstützenden Austrittsarbeit zur Ausbildung der Potenzialbarriere des Kontaktgitters (08).

6. Rückseitenkontaktierte Solarzelle nach Anspruch 1,
**GEKENNZEICHNET DURCH**
eine intrinsisch leitfähige Passivierschicht (15) mit Oberflächendipolen zur Unterstützung der Akkumulation der überschüssigen Majoritätsladungsträger und der Abstoßung der überschüssigen Minoritätsladungsträger.

7. Rückseitenkontaktierte Solarzelle nach Anspruch 1,
**GEKENNZEICHNET DURCH**
eine Ausbildung des Isolationsgitters (09) aus Aluminiumoxid als nicht dotiertem, elektrisch isolierendem Passiviermaterial hoher negativer Oberflächenladung bei einer p-typ dotierten Absorberschicht (02, 22) oder aus Siliziumnitrid als nicht dotiertem, elektrisch isolierendem Passiviermaterial hoher positiver Oberflächenladung bei einer n-typ dotierten Absorberschicht (02, 22).

8. Rückseitenkontaktierte Solarzelle nach Anspruch 1 oder 4,
**GEKENNZEICHNET DURCH**
eine Ausbildung der Absorberschicht (02, 22) und der Emitterschicht (07) aus Silizium, der intrinsisch leitfähigen Passivierschicht (15) aus intrinsischem, amorphem Silizium, der elektrisch isolierenden Passivierschicht (19) aus Siliziumoxid oder Siliziumnitrid und des Kontaktgitters (08) sowie der Kontaktfläche (13) aus Aluminium.

## Claims

1. Back contact solar cell (01, 20) at least having
• an absorber layer (02, 22) and an emitter layer (07) disposed on a rear side made of semiconductor materials of opposite p and n type doping,
• a metal contact grid (08) disposed between the absorber layer (02, 22) and the emitter layer (07) which is electrically insulated with respect to the emitter layer (07) by a congruent insulation grid (09), for collection of excess majority charge carriers produced by incidence of light in the absorber layer (02, 22), wherein insulation elements (18) of the insulation grid (09) have a lateral overlap width (L) over contact elements (11) of the contact grid (08),
• a continuous contact surface (13) disposed on the rear side on the emitter layer (07), for collection of excess minority charge carriers produced by incidence of light in the absorber layer (02, 22) and
• an unstructured intrinsically conductive passivation layer (15) disposed on the rear side, which is disposed at least between the individual contact elements (11) directly on the absorber layer (02, 22),
• an accumulation of excess majority charge carriers and repulsion of excess minority charge carriers from the absorber layer (02, 22) in the region of the contact grid (08) by
• a formation of the insulation grid (09) from a non-doped electrically insulating passivating material having a high surface charge with opposite polarity for doping the absorber layer (02, 22), wherein the surface charge is so high that a degeneration results at the surface of the absorber layer (02, 22) and
• a formation of the metal contact grid (08) with a potential barrier to the intrinsically conductive passivation layer (15) which supports the accumulation and repulsion
• such a lateral overlap width (L) of the insulation elements (18) of the insulation grid (09) over the contact elements (11) of the contact grid (08) that no majority charge carriers can flow from the emitter layer (07) to the contact elements (11) of the contact grid (08),
**characterized by**
• a full-surface arrangement of the intrinsically conductive passivation layer (15) directly on the entire absorber layer (02, 22) which is configured to be unstructured at its interface (16) to the intrinsically conductive passivation layer (15),
• a direct arrangement of the contact grid (08) on the intrinsically conductive passivation layer (15).

2. The back contact solar cell according to claim 1, **characterized by** a configuration with a wafer (03) as absorber layer (02) or with a superstrate (21) or substrate on which the absorber layer (22) is applied as thin layer.

3. The back contact solar cell according to claim 1, **characterized by** a configuration of the contact grid (08) with strip-shaped or punctuate contact elements (11).

4. The back contact solar cell according to claim 1, **characterized by** an unstructured electrically insulating passivation layer (19) disposed on the front side.

5. The back contact solar cell according to claim 1, **characterized by** a contact grid (08) made of metal with a work function which supports the accumulation of excess majority charge carriers and the repulsion of excess minority charge carriers to form the potential barrier of the contact grid (08).

6. The back contact solar cell according to claim 1, **characterized by** an intrinsically conductive passivation layer (15) with surface dipoles to support the accumulation of excess majority charge carriers and the repulsion of excess minority charge carriers.

7. The back contact solar cell according to claim 1, **characterized by** a formation of the insulation grid (09) from aluminium oxide as a non-doped electrically insulating passivating material having high negative surface charge with a p-type doped absorber layer (02, 22) or from silicon nitride as a non-doped electrically insulating passivating material having high positive surface charge with an n-type doped absorber layer (02, 22).

8. The back contact solar cell according to claim 1 or 4, **characterized by** formation of the absorber layer (02, 22) and the emitter layer (07) from silicon, the intrinsically conductive passivation layer (15) from intrinsic amorphous silicon, the electrically insulating passivation layer (19) from silicon dioxide or silicon nitride and the contact grid (08) and the contact surface (13) from aluminium.

## Revendications

1. Cellule photovoltaïque à contact arrière (01, 20) comportant au moins :
• une couche absorbante (02, 22) et une couche émettrice (07) disposée du côté arrière constitué de matériaux semiconducteurs à dopage p et n opposé,
• une grille de contact (08) métallique disposée entre la couche absorbante (02, 22) et la couche émettrice (07), qui est isolée électriquement par rapport à la couche émettrice (07) par une grille d'isolation (09) congruente, afin de collecter des porteurs majoritaires photo-générés excédentaires générés par l'incidence de lumière dans la couche absorbante (02, 22), dans laquelle les éléments d'isolation (18) de la grille d'isolation (09) ont une largeur de recouvrement latérale (L) par-dessus les éléments de contact (11) de la grille de contact (08),
• une surface de contact (13) de bout en bout disposée du côté arrière sur la couche émettrice (07) afin de collecter des porteurs majoritaires photo-générés excédentaires générés par l'incidence de lumière dans la couche absorbante (02, 22),
• une couche de passivation (15) intrinsèquement conductrice non structurée, disposée du côté arrière, qui est disposée au moins entre les éléments de contact individuels (11) directement sur la couche absorbante (02, 22),
• une accumulation des porteurs majoritaires photo-générés excédentaires et une répulsion des porteurs minoritaires photo-générés excédentaires provenant de la couche d'absorption (02, 22) au niveau de la grille de contact (08) par
• une configuration de la grille d'isolation (09) constituée d'un matériau de passivation isolant électriquement, non dopé à charge de surface élevée, avec une polarité opposée pour le dopage de la couche absorbante (02, 22), dans laquelle la charge de surface est élevée au point d'entraîner une dégénérescence sur la surface de la couche absorbante (02, 22) et
• une configuration de la grille de contact métallique (08) avec une barrière de potentiel assistant l'accumulation et la répulsion par rapport à la couche de passivation (15) intrinsèquement conductrice,
• une largeur de recouvrement (L) latérale des éléments d'isolation (18) de la grille d'isolation (09) par l'intermédiaire des éléments de contact (11) de la grille de contact (08), telle qu'aucun porteur majoritaire photo-généré ne puisse s'échapper de la couche émettrice (07) vers les éléments de contact (11) de la grille de contact (08),
**caractérisée par**
• une disposition sur la totalité de la surface de la couche de passivation (15) intrinsèquement conductrice directement sur la totalité de la couche absorbante (02, 22), qui est conçue de manière non structurée sur son interface (16) avec la couche de passivation (15) intrinsèquement non conductrice,
• une disposition directe de la grille de contact (08) sur la couche de passivation (15) intrinsèquement conductrice.

2. Cellule photovoltaïque à contact arrière selon la revendication 1, **caractérisée par** une configuration avec une plaquette (03) comme couche absorbante (02) ou avec un superstrat (21) ou substrat, sur lequel la couche absorbante (22) est appliquée comme couche mince.

3. Cellule photovoltaïque à contact arrière selon la revendication 1, **caractérisée par** une configuration de la grille de contact (08) avec des éléments de contact (11) en forme de bande ou en forme de point.

4. Cellule photovoltaïque à contact arrière selon la revendication 1, **caractérisée par** une couche de passivation (19) électriquement isolante, non structurée disposée du côté avant.

5. Cellule photovoltaïque à contact arrière selon la revendication 1, **caractérisée par** une grille de contact (08) constituée d'un métal avec une fonction de travail assistant l'accumulation des porteurs majoritaires photo-générés excédentaires et la répulsion des porteurs minoritaires photo-générés excédentaires afin de réaliser la barrière de potentiel de la grille de contact (08).

6. Cellule photovoltaïque à contact arrière selon la revendication 1, **caractérisée par** une couche de passivation (15) intrinsèquement conductrice (15) avec des dipôles de surface pour assister l'accumulation des porteurs majoritaires photo-générés excédentaires et la répulsion des porteurs minoritaires photo-générés excédentaires.

7. Cellule photovoltaïque à contact arrière selon la revendication 1, **caractérisée par** une configuration de la grille d'isolation (09) constituée d'oxyde d'aluminium comme un matériau de passivation électriquement isolant, non dopé à charge de surface négative élevée en présence d'une couche absorbante (02, 22) p-dopée ou constituée de nitrure de silicium comme matériau de passivation électriquement isolant, non dopé à charge de surface positive élevée en présence d'une couche absorbante (02, 22) n-dopée.

8. Cellule photovoltaïque à contact arrière selon la revendication 1 ou 4, **caractérisée par** une configuration de la couche absorbante (02, 22) et de la couche émettrice (07) en silicium, la couche de passivation (15) intrinsèquement conductrice en silicium intrinsèquement amorphe, la couche de passivation (19) électriquement isolante en oxyde de silicium ou nitrure de silicium et de la grille de contact (08) ainsi que de la surface de contact (13) en aluminium.
